# EUROPEAN PATENT APPLICATION

(11) **EP 4 641 234 A1**
(43) Date of publication of application: **29.10.2025**
(21) Application number: 23909006.1
(22) Date of filing: 06.06.2023
(51) Int. Cl.: G01R 31/396

(54) **METHOD FOR DETECTING SELF-DISCHARGE STATE OF BATTERY PACK, VEHICLE, AND COMPUTER STORAGE MEDIUM**

(30) Priority: 29.12.2022 CN 202211704489
(71) Applicant: BYD Company Limited, Shenzhen, Guangdong 518118 (CN)
(72) Inventor: FENG, Tianyu, Shenzhen, Guangdong 518118 (CN); SHU, Shiwei, Shenzhen, Guangdong 518118 (CN); DENG, Linwang, Shenzhen, Guangdong 518118 (CN)
(74) Representative: Taor, Simon Edward William
(86) International application number: PCT/CN2023/098525
(87) International publication number: WO 2024/139059

(57) **Abstract**

A method for detecting a self-discharge state of a battery pack, a vehicle, and a computer storage medium. The method for detecting a self-discharge state of a battery pack comprises: acquiring charging and discharging data of each cell in a battery pack (S1); generating a dQ/dV curve of each cell according to the charging and discharging data (S2); determining voltage inflection point feature information according to the dQ/dV curve of each cell (S3); and determining a self-discharge state of the battery pack according to the voltage inflection point feature information of each cell (S4).

## Description

### CROSS-REFERENCE TO RELATED APPLICATIONS

The present disclosure claims priority to Chinese Patent Application No. 202211704489.1 filed with China National Intellectual Property Administration on December 29, 2022, titled "Method for detecting self-discharge state of battery pack, vehicle and computer storage medium", which is incorporated herein by reference in its entirety.

### FIELD

The present disclosure relates to the field of vehicle technologies, and in particular, to a method for detecting a self-discharge state of a battery pack, a vehicle and a computer storage medium.

### BACKGROUND

For transportation vehicles such as electric vehicles, electric airplanes, and electric ships, a plurality of batteries need to be connected in series or parallel to provide the necessary power. However, due to cost and technological limitations, battery manufacturers are unable to achieve complete consistency in the production of battery cells, and some cells may even exhibit extreme self-discharge anomalies. If one of the battery cells in the entire package has abnormal self-discharge, it can cause vehicles, ships, and airplanes to break down, and even lead to serious consequences such as thermal runaway. Therefore, detecting abnormal self-discharge of battery cells is crucial for the lithium electronic battery market.

### SUMMARY

The present disclosure aims to solve at least one of the technical problems existing in the prior art. Therefore, an object of the present disclosure is to propose a method for detecting a self-discharge state of a battery pack, and a self-discharge situation of a single cell in the battery pack can be detected by using the method.

A second object of the present disclosure is to propose a vehicle.

A third object of the present disclosure is to propose a computer storage medium.

In order to solve the above problems, an embodiment according to a first aspect of the present disclosure provides a method for detecting a self-discharge state of a battery pack, and the method includes: charging and discharging data of each single cell in the battery pack are obtained; a dQ/dV-capacity curve of each single cell is generated according to the charging and discharging data; voltage inflection point characteristic information is determined according to the dQ/dV-capacity curve of each single cell, the self-discharge state of the battery pack is determined according to the voltage inflection point characteristic information.

According to the method for detecting the self-discharge state of the battery pack in the embodiment of the present disclosure, the dQ/dV-capacity curve of each single cell is generated by using the charging and discharging data of each single cell of the battery pack during use, and the voltage inflection point characteristic information of each single cell is determined according to the dQ/dV-capacity curve of each single cell, thereby the self-discharge state of the battery pack is judged through the difference between the voltage inflection point characteristic information of each single cell, thereby the detection of a self-discharge situation of the single cell in the battery pack is realized, moreover, the application scenario of the method is not limited, and the method can be applied to the detection of the self-discharge state of the battery pack throughout the entire life cycle thereof, with a wider range of applicability.

In some embodiments, the dQ/dV-capacity curve of each single cell is generated according to the charging and discharging data, which includes: an SOC value of each single cell at an initial time of entering a charging/discharging phase is obtained; an initial capacity value of each single cell at an initial time of charging/discharging is obtained according to a nominal capacity value of each single cell and the SOC value; after entering the charging/discharging phase, a capacity increment of each single cell at each time is obtained; a real-time capacity value of each single cell in the charging/discharging phase is obtained according to the initial capacity value and the capacity increment; a real-time voltage value of each single cell in the charging/discharging phase is obtained, and the dQ/dV-capacity curve of each single cell is generated according to the initial capacity value, the real-time capacity value and the real-time voltage value.

In some embodiments, the voltage inflection point characteristic information is determined according to the dQ/dV-capacity curve of each single cell, which includes: a first dQ/dV-capacity curve in which a high voltage inflection point occurs earliest, a second dQ/dV-capacity curve in which the high voltage inflection point occurs latest, and a third dQ/dV-capacity curve in which a low voltage inflection point occurs latest among all dQ/dV-capacity curves are obtained; a first capacity value corresponding to a first high voltage inflection point in the first dQ/dV-capacity curve according to the first dQ/dV-capacity curve is obtained; a second capacity value corresponding to a second high voltage inflection point in the second dQ/dV-capacity curve according to the second dQ/dV-capacity curve is obtained; a third capacity value corresponding to a low voltage inflection point in the third dQ/dV-capacity curve according to the third dQ/dV-capacity curve is obtained.

In some embodiments, the self-discharge state of the battery pack is determined according to the voltage inflection point characteristic information, which includes: a first difference value between the second capacity value and the first capacity value is obtained, and the self-discharge state of the battery pack is determined according to the first difference value; and/or, a second difference value between the first capacity value and the third capacity value is obtained, and the self-discharge state of the battery pack is determined according to the second difference value; and/or, a theoretical capacity value of the single cell corresponding to a third high voltage inflection point in a theoretical dQ/dV-capacity curve is obtained, a third difference value between the second capacity value and the theoretical capacity value is obtained , and the self-discharge state of the battery pack is determined according to the third difference value.

In some embodiments, the self-discharge state of the battery pack is determined according to the first difference value, which includes: whether the first difference value is within a first preset capacity range is judged; if not, the self-discharge state of the single cell corresponding to the second dQ/dV-capacity curve is determined to be abnormal self-discharge.

In some embodiments, the self-discharge state of the battery pack is determined according to the second difference value, which includes: whether the second difference value is within a second preset capacity range is judged; if not, the self-discharge state of the single cell corresponding to the third dQ/dV-capacity curve is determined to be abnormal self-discharge.

In some embodiments, the self-discharge state of the battery pack is determined according to a SOC deviation value, which includes: whether the third difference value is within a third preset capacity range is judged; if not, the self-discharge state of the single cell corresponding to the second dQ/dV-capacity curve is determined to be abnormal self-discharge.

In some embodiments, the method further includes: when the first difference value is within the first preset capacity range, the second difference value is within the second preset capacity range, and the third difference value is within the third preset capacity range is determined , the self-discharge state of the battery pack is determined to be normal self-discharge.

An embodiment according to a second aspect of the present disclosure provides a vehicle, the vehicle includes: at least one processor and a memory communicatively connected to the at least one processor, wherein, the memory stores a computer program that can be executed by the at least one processor, and when the at least one processor executes the computer program, the method for detecting the self-discharge state of the battery pack in the above embodiments is implemented.

According to the vehicle in the embodiment of the present disclosure, by adopting the method for detecting the self-discharge state of the battery pack provided in the above embodiments, the detection of the self-discharge situation of the single cell in the battery pack can be realized.

An embodiment according to a third aspect of the present disclosure provides a computer storage medium, a computer program is stored thereon, when the computer program is executed by a processor, the method for detecting a self-discharge state of a battery pack in the above embodiments is realized.

Additional aspects and advantages of the present disclosure will be partially presented in the following description, and some of which will become apparent from the following description, or learned by the practice of the present disclosure.

### BRIEF DESCRIPTION OF THE DRAWINGS

The above and/or additional aspects and advantages of the present disclosure will become apparent and easily understood from the description of embodiments in conjunction with the following figures, wherein:
FIG. 1 is a flowchart of a method for detecting a self-discharge state of a battery pack according to an embodiment of the present disclosure.
FIG. 2 is a flowchart of a method for detecting a self-discharge state of a battery pack according to another embodiment of the present disclosure;
FIG. 3 is a structural block diagram of a vehicle according to an embodiment of the present disclosure.

Reference signs:
vehicle 10;
processor 1; memory 2.

### DETAILED DESCRIPTION

The embodiments described with reference to the accompanying drawings are exemplary, and embodiments of the present disclosure are described in detail below.

In order to solve the above problems, an embodiment according to a first aspect of the present disclosure provides a method for detecting a self-discharge state of a battery pack, and a self-discharge situation of a single cell in the battery pack can be detected by using the method.

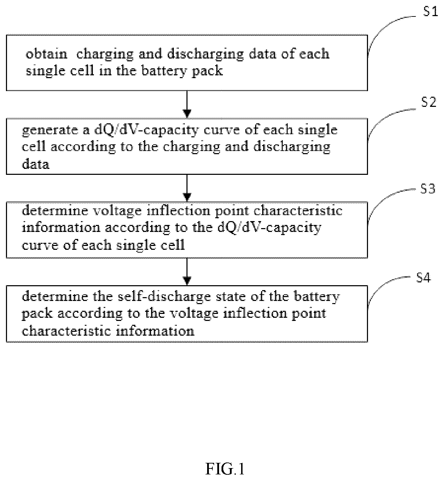

A method for detecting a self-discharge state of a battery pack according to an embodiment of the present disclosure will be described with reference to FIG. 1, and as shown in FIG. 1, the method includes at least steps S1 to S4.

In step S1, charging and discharging data of each single cell in the battery pack are obtained.

In the embodiment, during the charging and discharging process of the battery pack, the charging and discharging data such as current, voltage, temperature, or SOC of each single cell will also change accordingly, therefore, a battery manager corresponding to the battery pack will monitor the charging and discharging data of each single cell in the battery pack in real time during use, and upload the detected charging and discharging data to the cloud server for subsequent retrieval and use.

In step S2, a dQ/dV-capacity curve of each single cell is generated according to the charging and discharging data. That is to say, the dQ/dV-capacity curve corresponding to each single cell is drawn by using the charging and discharging data. For example, if the number of the single cells in the battery pack is N, each single cell corresponds to a dQ/dV-capacity curve, that is, the total number of the dQ/dV-capacity curves is N.

In some embodiments, when the dQ/dV-capacity curve of each single cell is generated according to the charging and discharging data, an SOC value of each single cell at an initial time of entering the charging/discharging phase is obtained. According to a nominal capacity value of each single cell, denoted as Qn and SOC value, an initial capacity value of each single cell at an initial time of charging/discharging is obtained, such as the expression formula is the initial capacity value = Qn * SOC value. Furthermore, after entering the charging/discharging phase, with the change of usage time, a capacity value of each single cell will change on the basis of the initial capacity value, for example, the capacity value gradually increases in a charging phase, while the capacity value will gradually decrease in a discharging phase, in this process, a capacity increment of each single cell at each time is obtained, and the capacity increment = current * interval time. A real-time capacity value of each single cell in the charging/discharging phase is obtained according to the initial capacity value and the capacity increment. Specifically, a capacity value at the current time is obtained by summing the capacity increment and a capacity value at the previous time, thereby the real-time capacity value at each time is obtained. A real-time voltage value of each single cell in the charging/discharging phase is obtained, and the dQ/dV-capacity curve of each single cell is generated according to the initial capacity value, the real-time capacity value and the real-time voltage value. Specifically, a capacity-voltage value curve of each single cell can be drawn according to the initial capacity value and the real-time capacity value and the real-time voltage value corresponding to each time, the capacity-voltage value curve is smoothly filtered, and the dQ/dV-capacity curve of each single cell can be obtained by calculating the difference between voltage and capacity.

In the embodiment, before drawing the dQ/dV-capacity curve using the charge/discharge data, the obtained charging/discharging data are cleaned to screen and remove abnormal or missing data caused by hardware failure, communication failure such as network disconnection or parsing error, and the data are sorted by time, that is, sorted in ascending order according to the occurrence time of the data, thereby deleting data streams at the same time, reducing data redundancy, and improving detection efficiency.

In step S3: voltage inflection point characteristic information is determined according to the dQ/dV-capacity curve of each single cell.

In an embodiment, the voltage-capacity curve of the battery pack includes three areas characterized by relatively slow voltage change, hereinafter referred to as voltage plateaus. An area characterized by relatively rapid voltage change is between two voltage plateaus, the point with maximum rate of change in the area is referred to as a voltage inflection point, the voltage inflection point is distinguished by the voltage level, a relatively higher voltage is referred to as a high voltage inflection point (denoted as HVTP), and a relatively lower voltage is referred to as a low voltage inflection point (denoted as LVTP), in practical applications, it is necessary to distinguish the high voltage inflection point and the low voltage inflection point of each cell. According to the above, the voltage inflection point characteristic information of each single cell is determined by the dQ/dV-capacity curve, wherein, the voltage inflection point characteristic information at least includes a position of an inflection point position, a voltage value corresponding to the inflection point, and a capacity value corresponding to the inflection point.

In step S4, the self-discharge state of the battery pack is determined according to the voltage inflection point characteristic information.

Specifically, since the battery pack is composed of a plurality of single cells connected in series, in an AC charging or discharging process, since the current in a series circuit is equal everywhere, changes in SOC values of all single cells at each time are theoretically the same, therefore, for the same battery pack, an actual SOC value corresponding to the voltage inflection point of each single cell is also the same. According to this, it can be clearly known that the difference in the positions of the voltage inflection points of the battery pack during use can represent the difference in the actual SOC values in each single cell, and the self-discharge situation of each single cell can also be known. Therefore, in the present disclosure the dQ/dV-capacity curve of each single cell is generated by using the charging and discharging data of each single cell of the battery pack during use, and the voltage inflection point characteristic information of each single cell is determined according to the dQ/dV-capacity curve of each single cell, thereby the self-discharge state of the battery pack is judged through the difference between the voltage inflection point characteristic information of each single cell, thereby the detection of the self-discharge situation of the single cell in the battery pack is realized, moreover, the application scenario of the method is not limited, and the method can be applied to the detection of the self-discharge state of the battery pack throughout the entire life cycle thereof, with a wider range of applicability.

According to the method for detecting the self-discharge state of the battery pack in the embodiment of the present disclosure, the dQ/dV-capacity curve of each single cell is generated by using the charging and discharging data of each single cell of the battery pack during use, and the voltage inflection point characteristic information of each single cell is determined according to the dQ/dV-capacity curve of each single cell, thereby the self-discharge state of the battery pack is judged through the difference between the voltage inflection point characteristic information of each single cell, thereby the detection of the self-discharge situation of the single cell in the battery pack is realized, moreover, the application scenario of the method is not limited, and the method can be applied to the detection of the self-discharge state of the battery pack throughout the entire life cycle thereof, with a wider range of applicability.

In some embodiments, the voltage inflection point characteristic information is determined according to the dQ/dV-capacity curve of each single cell, which includes: a first dQ/dV-capacity curve in which the high voltage inflection point occurs earliest, a second dQ/dV-capacity curve in which the high voltage inflection point occurs latest, and a third dQ/dV-capacity curve in which the low voltage inflection point occurs latest among all dQ/dV-capacity curves are obtained; a first capacity value corresponding to a first high voltage inflection point, i.e. a high voltage peak value, in the first dQ/dV-capacity curve according to the first dQ/dV-capacity curve is obtained; a second capacity value corresponding to a second high voltage inflection point, i.e. a high voltage peak value, in the second dQ/dV-capacity curve according to the second dQ/dV-capacity curve is obtained; a third capacity value corresponding to a low voltage inflection point, i.e. a low voltage peak value, in the third dQ/dV-capacity curve according to the third dQ/dV-capacity curve is obtained.

In some embodiments, the self-discharge state of the battery pack is determined according to the voltage inflection point characteristic information of each single cell, which includes: a first difference value between the second capacity value and the first capacity value is obtained, and the self-discharge state of the battery pack according to the first difference value is determined (that is, the first capacity value Q1 corresponding to the earliest occurrence of HVTP in the charging/discharging phase is subtracted from the second capacity value Q2 corresponding to the latest occurrence of HVTP, that is, the first difference △ Q1=Q2-Q1, and the self-discharge state of the battery pack is judged by the calculated first difference value); and/or
a second difference value between the first capacity value and the third capacity value is obtained, and the self-discharge state of the battery pack according to the second difference value is determined (that is, the third capacity value Q3 corresponding to the latest occurrence of LVTP in the charging/discharging phase is subtracted from the first capacity value Q1 corresponding to the earliest occurrence of HVTP, that is, the second difference △ Q2=Q1-Q3, and the self-discharge state of the battery pack is judged by the calculated second difference value); and/or
a theoretical capacity value of the single cell corresponding to a third high voltage inflection point in a theoretical dQ/dV-capacity curve is obtained (wherein, the theoretical dQ/dV-capacity curve can be understood as a curve formed theoretically by each single cell according to the change of capacity and voltage thereof before the battery pack is put into practical application, according to this, the theoretical capacity value can be understood as the capacity value of each single cell corresponding to the high voltage inflection point theoretically when no self-discharge abnormal situation occurs, a third difference value between the second capacity value Q2 and the theoretical capacity value Q _ HVTP is obtained (that is, the second capacity value Q2 corresponding to the latest occurrence of HVTP in the charging/discharging phase is subtracted from the theoretical capacity value of the single cell corresponding to the high voltage inflection point, that is, the third difference value Q3 = Q _ HVTP-Q2), and the self-discharge state of the battery pack is determined according to the third difference value.

It should be noted that during the use of the battery pack, if the usage time is short, the voltage inflection point may not occur, therefore, in actual use, the self-discharge state of the battery pack may be judged by any one of the first difference value, the second difference value, and the third difference value according to the actual situation, or, the self-discharge state of the battery pack may be judged by any two of them, or, the self-discharge state of the battery pack may be judged by the above three terms at the same time, and this is not limited.

In some embodiments, whether the first difference value is within a first preset capacity range is judged; if not, that is, the first difference value is not within the first preset capacity range, it means that the difference value between the first capacity value Q1 corresponding to the earliest occurrence of HVTP and the second capacity value Q2 corresponding to the latest occurrence of HVTP is too large, and the single cell corresponding to the latest occurrence of HVTP has the self-discharge situation, that is, the self-discharge state of the single cell corresponding to the second dQ/dV-capacity curve is determined to be abnormal self-discharge.

In some embodiments, whether the second difference value is within a second preset capacity range is judged; if not, that is, the second difference value is not within the second preset capacity range, it means that the difference value between the first capacity value Q1 corresponding to the earliest occurrence of HVTP and the third capacity value Q3 corresponding to the latest occurrence of LVTP is too small, and the single cell corresponding to the latest occurrence of LVTP has the self-discharge situation, that is, the self-discharge state of the single cell corresponding to the third dQ/dV-capacity curve is determined to be abnormal self-discharge.

In some embodiments, whether the third difference value is within a third preset capacity range is determined; if not, that is, the third difference value is not within the third preset capacity range, it means that the second capacity value Q2 corresponding to the latest occurrence of HVTP does not match the capacity value corresponding to the latest occurrence of HVTP theoretically, and thus the self-discharge state of the single cell corresponding to the second dQ/dV-capacity curve is determined to be abnormal self-discharge.

In some embodiments, when the self-discharge state of the battery pack is judged by the first difference value, the second difference value, and a SOC deviation value simultaneously, as long as any of them does not meet the preset range, it means that the battery pack has an abnormal self-discharge situation; when the first difference value is within the first preset capacity range, the second difference value is within the second preset capacity range, and the third difference value is within the third preset capacity range is determined , the self-discharge state of the battery pack is determined to be normal self-discharge.

In some embodiments, the first preset capacity range, the second preset capacity range, and the third preset capacity range are values that are preset according to actual characteristics of the single cell during factory testing, and this is not limited.

In some embodiments, the present disclosure can provide an early warning prompt when the abnormal self-discharge of a single cell is detected to inform the user of the fault in advance and avoid accidents.

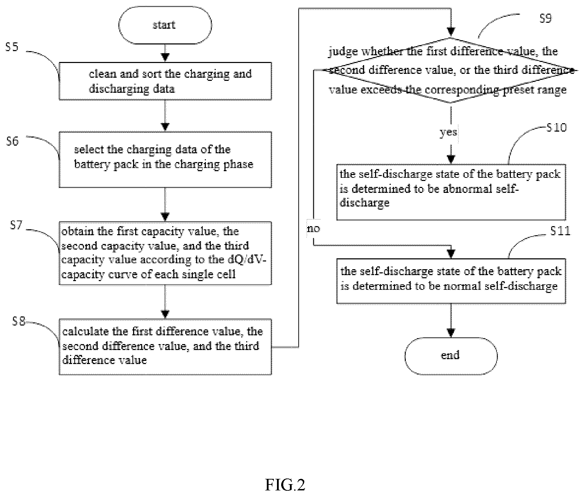

The method for detecting the self-discharge state of the battery pack according to an embodiment of the present disclosure will be described as an example with reference to FIG. 2, and the specific steps are as follows, wherein, the battery pack is in a charging phase as an example.

In step S5, the charging and discharging data are cleaned and sorted.

In step S6, the charging data of the battery pack in the charging phase are selected and the data in the charging phase are merged.

In step S7, the first capacity value, the second capacity value, and the third capacity value are obtained according to the dQ/dV-capacity curve of each single cell.

In step S8, the first difference value, the second difference value, and the third difference value are calculated.

In step S9, whether the first difference value, the second difference value, or the third difference value exceeds the corresponding preset range is judged. If so, step S10 is executed; if none of the first difference value, the second difference value, and the third difference value exceeds the corresponding preset range, step S11 is executed.

In step S10, the self-discharge state of the battery pack is determined to be abnormal self-discharge.

In step S11, the self-discharge state of the battery pack is determined to be normal self-discharge.

In summary, according to the method for detecting the self-discharge state of the battery pack in the embodiment of the present disclosure, the dQ/dV-capacity curve corresponding to each single cell is generated by the charging and discharging data of all single cells during use of the battery pack, and the voltage inflection point characteristic information is determined by analyzing the curve characteristics, so that the entire life cycle of the battery pack can be monitored, and the method is not limited to the factory stage of the cells, does not require long-term static placement of the battery pack, and does not require judgment according to different vehicle models and aging levels, therefore, the application scenario of the present disclosure is not limited, the scope of use is wider, and it is more in line with user habits, making it easier for users to understand the self-discharge state of the battery pack at any time.

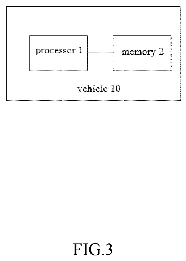

An embodiment of a second aspect of the present disclosure provides a vehicle, and as shown in FIG. 3, the vehicle 10 includes at least one processor 1 and a memory 2 communicatively connected to the at least one processor 1.

Wherein, the memory 2 stores a computer program that can be executed by the at least one processor 1, and when the at least one processor 1 executes the computer program, the method for detecting the self-discharge state of the battery pack in the above embodiments is implemented.

It should be noted that the specific implementation of the vehicle 10 in the embodiment of the present disclosure is similar to the specific implementation of the method for detecting the self-discharge state of the battery pack in any of the above embodiments of the present disclosure. For details, please refer to the description of the method section, and in order to reduce redundancy, the description will not be repeated here.

According to the vehicle 10 in the embodiment of the present disclosure, by adopting the method for detecting the self-discharge state of the battery pack provided in the above embodiments, the detection of the self-discharge situation of the single cell in the battery pack can be realized.

An embodiment of a third aspect of the present disclosure provides a computer storage medium, a computer program is stored thereon, when the computer program is executed by a processor, the method for detecting a self-discharge state of a battery pack in the above embodiments is realized.

In the description of this specification, any process or method description described in the flowcharts or otherwise described herein may be understood to represent a module, segment, or portion of code that includes one or more executable instructions for implementing steps of a customized logical function or process, and the scope of preferred embodiments of the present disclosure includes additional implementations in which functions may be performed not in the order shown or discussed, including in a substantially simultaneous manner or in the reverse order according to the functions involved, as should be understood by a person skilled in the art to which the embodiments of the present disclosure belong.

The logic and/or steps represented in the flowcharts or otherwise described herein, for example, may be considered a defined sequence of executable instructions for implementing logical functions, may be embodied in any computer-readable medium for use by, or in connection with, an instruction execution system, apparatus, or device, such as a computer-based system, a system including a processor, or other system that may fetch and execute instructions from an instruction execution system, apparatus, or device. For the purposes of this specification, a "computer-readable medium" may be any device that may contain, store, communicate, propagate, or transmit a program for use by or in connection with an instruction execution system, apparatus, or apparatus. More specific examples (non-exhaustive list) of computer-readable media include the following: electrical connections (electronic devices) having one or more wirings, portable computer cartridges (magnetic devices), random access memories (RAM), read-only memories (ROM), erasable editable read-only memories (EPROM or flash memories), optical fiber devices, and portable optical disc read-only memories (CDROM). In addition, the computer-readable medium may even be paper or other suitable medium on which the program may be printed, since the program may be obtained electronically, for example, by optical scanning of the paper or other medium, followed by editing, interpretation or, if necessary, processing in other suitable manners, and then stored in a computer memory.

It should be understood that portions of the present application may be implemented in hardware, software, firmware, or a combination thereof. In the embodiments described above, the steps or methods may be implemented with software or firmware stored in memory and executed by a suitable instruction execution system. For example, if implemented in hardware as in another embodiment, it may be implemented with any of the following techniques known in the art or a combination thereof: discrete logic circuits having logic gates for implementing logic functions on data signals, application specific integrated circuits having suitable combinational logic gates, programmable gate arrays (PGAs), field programmable gate arrays (FPGAs), etc.

One of ordinary skill in the art will understand that all or part of the steps involved in implementing the method of the above embodiments can be accomplished by instructing related hardware by a program stored in a computer-readable storage medium, and when executed, the program includes one or a combination of the steps of the method embodiments.

In addition, each functional unit in each embodiment of the present application may be integrated in one processing module, each unit may physically exist alone, or two or more units may be integrated in one module. The above integrated modules can be implemented in the form of hardware or software functional modules. The integrated module can also be stored in the computer-readable storage medium, if implemented as a software function module and sold or used as a stand-alone product.

The storage medium mentioned above may be a read-only memory, a magnetic disk, an optical disk, or the like. Although the embodiments of the present application have been shown and described above, it is to be understood that the above embodiments are exemplary and should not be understood as limitations of the present application, and a person skilled in the art can make changes, modifications, substitutions and modifications to the above embodiments within the scope of the present application.

In the description of the present specification, a description with reference to the terms "one embodiment," "some embodiments," "exemplary embodiments," "examples," "specific examples," or "some examples," etc. means that a specific feature, structure, material, or characteristic described in connection with the embodiment or example is included in at least one embodiment or example of the present application. In the present specification, schematic expressions of the above terms do not necessarily refer to the same embodiments or examples.

While embodiments of the present application have been shown and described, those of ordinary skill in the art will understand that various changes, modifications, substitutions, and variations can be made to these embodiments without departing from the principles and spirits of the present application, the scope of which is defined by the claims and their equivalents.

## Claims

1. A method for detecting a self-discharge state of a battery pack, comprising:
obtaining (S1) charging and discharging data of each single cell in the battery pack;
generating (S2) a dQ/dV-capacity curve of each single cell according to the charging and discharging data;
determining (S3) voltage inflection point characteristic information according to the dQ/dV-capacity curve of each single cell;
determining (S4) the self-discharge state of the battery pack according to the voltage inflection point characteristic information.

2. The method for detecting a self-discharge state of a battery pack according to claim 1, wherein the generating (S2) a dQ/dV-capacity curve of each single cell according to the charging and discharging data comprises:
obtaining an SOC value of each single cell at an initial time of entering a charging/discharging phase;
obtaining an initial capacity value of each single cell at an initial time of charging/discharging according to a nominal capacity value of each single cell and the SOC value;
after entering the charging/discharging phase, obtaining a capacity increment of each single cell at each time;
obtaining a real-time capacity value of each single cell in the charging/discharging phase according to the initial capacity value and the capacity increment;
obtaining a real-time voltage value of each single cell in the charging/discharging phase;
generating the dQ/dV-capacity curve of each single cell according to the initial capacity value, the real-time capacity value and the real-time voltage value.

3. The method for detecting a self-discharge state of a battery pack according to claim 1 or 2, wherein the determining (S3) voltage inflection point characteristic information according to the dQ/dV-capacity curve of each single cell comprises:
obtaining a first dQ/dV-capacity curve in which a high voltage inflection point occurs earliest, a second dQ/dV-capacity curve in which the high voltage inflection point occurs latest, and a third dQ/dV-capacity curve in which a low voltage inflection point occurs latest among all dQ/dV-capacity curves;
obtaining a first capacity value corresponding to a first high voltage inflection point in the first dQ/dV-capacity curve according to the first dQ/dV-capacity curve;
obtaining a second capacity value corresponding to a second high voltage inflection point in the second dQ/dV-capacity curve according to the second dQ/dV-capacity curve;
obtaining a third capacity value corresponding to a low voltage inflection point in the third dQ/dV-capacity curve according to the third dQ/dV-capacity curve.

4. The method for detecting a self-discharge state of a battery pack according to claim 3, wherein the determining (S4) the self-discharge state of the battery pack according to the voltage inflection point characteristic information comprises:
obtaining a first difference value between the second capacity value and the first capacity value;
determining the self-discharge state of the battery pack according to the first difference value;
and/or, obtaining a second difference value between the first capacity value and the third capacity value;
determining the self-discharge state of the battery pack according to the second difference value;
and/or, obtaining a theoretical capacity value of the single cell corresponding to a third high voltage inflection point on a theoretical dQ/dV-capacity curve;
obtaining a third difference value between the second capacity value and the theoretical capacity value;
determining the self-discharge state of the battery pack according to the third difference value.

5. The method for detecting a self-discharge state of a battery pack according to claim 4, wherein the determining the self-discharge state of the battery pack according to the first difference value comprises:
judging whether the first difference value is within a first preset capacity range;
if not, determining that the self-discharge state of the single cell corresponding to the second dQ/dV-capacity curve is abnormal self-discharge.

6. The method for detecting a self-discharge state of a battery pack according to claim 4 or 5, wherein the determining the self-discharge state of the battery pack according to the second difference value comprises:
judging whether the second difference value is within a second preset capacity range;
if not, determining that the self-discharge state of the single cell corresponding to the third dQ/dV-capacity curve is abnormal self-discharge.

7. The method for detecting a self-discharge state of a battery pack according to any one of claims 4 to 6, wherein the determining the self-discharge state of the battery pack according to an SOC deviation value comprises:
judging whether the third difference value is within a third preset capacity range;
if not, determining that the self-discharge state of the single cell corresponding to the second dQ/dV-capacity curve is abnormal self-discharge.

8. The method for detecting a self-discharge state of a battery pack according to any one of claims 4 to 7, further comprising:
when the first difference value is within the first preset capacity range, the second difference value is within the second preset capacity range, and the third difference value is within the third preset capacity range , the self-discharge state of the battery pack is determined to be normal self-discharge.

9. A vehicle (10), comprising:
at least one processor (1); and
a memory (2), the memory (2) communicatively connected to the at least one processor (1), wherein, a computer program is stored in the memory (2)and executable by the at least one processor (1), when the at least one processor (1) executes the computer program, the method for detecting a self-discharge state of a battery pack according to any one of claims 1 to 8 is implemented .

10. A computer storage medium, storing a computer program which, when executed by a processor, implements the method for detecting a self-discharge state of a battery pack according to any one of claims 1 to 8.
